(19) Europäisches Patentamt
European Patent Office
Office européen des brevets

(11) **EP 1 552 561 B1**

(12) **EUROPÄISCHE PATENTSCHRIFT**

(45) Veröffentlichungstag und Bekanntmachung des Hinweises auf die Patenterteilung:
**09.12.2009 Patentblatt 2009/50**

(21) Anmeldenummer: **03757707.9**

(22) Anmeldetag: **10.10.2003**

(51) Int Cl.:
*H01L 27/12* (2006.01)    *H01L 21/84* (2006.01)

(86) Internationale Anmeldenummer:
**PCT/DE2003/003354**

(87) Internationale Veröffentlichungsnummer:
**WO 2004/038802 (06.05.2004 Gazette 2004/19)**

(54) **INTEGRIERTE SCHALTUNGSANORDNUNG MIT KONDENSATOREN UND MIT VORZUGSWEISE PLANAREN TRANSISTOREN UND HERSTELLUNGSVERFAHREN**

INTEGRATED CIRCUIT ARRANGEMENT COMPRISING CAPACITORS AND PREFERABLY PLANAR TRANSISTORS, AND PRODUCTION METHOD

CIRCUIT INTEGRE COMPRENANT DES CONDENSATEURS ET DES TRANSISTORS DE PREFERENCE A STRUCTURE PLANE ET PROCEDE DE PRODUCTION DE CE CIRCUIT

(84) Benannte Vertragsstaaten:
**DE FR IT**

(30) Priorität: **18.10.2002 DE 10248723**

(43) Veröffentlichungstag der Anmeldung:
**13.07.2005 Patentblatt 2005/28**

(73) Patentinhaber: **Infineon Technologies AG
81669 München (DE)**

(72) Erfinder:
• **BREDERLOW, Ralf
81827 München (DE)**
• **HARTWICH, Jessica
85579 Neubiberg (DE)**
• **PACHA, Christian
81739 München (DE)**
• **RÖSNER, Wolfgang
85521 Ottobrunn (DE)**
• **SCHULZ, Thomas
Austin, TX 78741 (US)**

(74) Vertreter: **Karl, Frank
Kindermann Patentanwälte
Postfach 100234
85593 Baldham (DE)**

(56) Entgegenhaltungen:
**US-A- 4 753 896    US-A- 5 998 807
US-A- 6 133 075    US-A- 6 140 162
US-B1- 6 414 345    US-B1- 6 417 057**

• **PATENT ABSTRACTS OF JAPAN Bd. 2000, Nr. 14, 5. März 2001 (2001-03-05) -& JP 2000 312006 A (SEIKO EPSON CORP), 7. November 2000 (2000-11-07) & US 6 569 717 B1 (MURADE MASAO) 27. Mai 2003 (2003-05-27)**

EP 1 552 561 B1

**Beschreibung**

Die Erfindung betrifft eine integrierte Schaltungsanordnung, die einen elektrisch isolierenden Isolierbereich und mindestens einen Kondensator enthält. Der Kondensator wird aus einer Bereichsfolge gebildet, die in der angegebenen Reihenfolge enthält:

- einen isolierbereichsnahen Elektrodenbereich,
- einen dielektrischen Bereich, und
- einen isolierbereichsfernen Elektrodenbereich.

Der elektrisch isolierende Isolierbereich besteht beispielsweise aus einem elektrisch isolierenden Material mit einem spezifischen Widerstand größer als $10^{12}$ $\Omega$m (Ohm mal Zentimeter) bei 20°C Raumtemperatur, z.B. aus einem Oxid, insbesondere aus Siliziumdioxid. Der Elektrodenbereich enthält beispielsweise ein Metall mit einem spezifischen elektrischen Widerstand kleiner als $10^{-4}$ $\Omega$cm bei 20°C Raumtemperatur. Alternativ enthalten die Elektrodenbereiche beispielsweise polykristallines Silizium, das hochdotiert ist. Der dielektrische Bereich besteht ebenfalls aus einem elektrisch isolierenden Material, z.B. aus einem Oxid, insbesondere aus Siliziumdioxid, das eine Dielektrizitätskonstante von etwa 3,9 hat. Jedoch werden auch dielektrische Materialien mit einer wesentlich größeren Dielektrizitätskonstante im dielektrischen Bereich verwendet.

Aus der JP 2000-312006 A ist ein Verfahren zum Herstellen einer Matrix aus TFT's (Thin Film Transistor) und Kondensatoren bekannt. Die Matrix soll für LCD-Geräte (Liquid Cristal Device) oder TFT-DRAMs verwendet werden. Die US 4,753,896 betrifft ein Verfahren zum Herstellen von Kanalstopdotierungen an Seitenwänden. Außerdem wird eine Silizidierung erwähnt. Die US 5,998,807 betrifft einen CMOS-Prozess, bei dem nach dem Rückätzen eines Source/Drain-Bereiches eines PMOS-Transistors eine selektive Epitaxie gefolgt von einer Silizidierung ausgeführt wird.

Aus der US 6,462,364 B1 sind MOS-Transistoren auf SOI-Substraten bekannt. Hilfstransistoren und/oder Widerstände werden verwendet, um den Schwebepotentialeffekt zu vermeiden. Als Anwendungen werden DRAM bzw. Signaltransferprozessoren genannt. Aus der US 6,462,723 B1 ist ein TFT-Display bekannt, das auch Treiberschaltungen und einfache Signalverarbeitende Schaltungen enthält. Veränderungen der Schwellspannung werden durch rückseitige Gateelektroden vermindert.

Es ist Aufgabe der Erfindung, eine einfach herzustellende integrierte Schaltungsanordnung mit Kondensator anzugeben. Die Schaltungsanordnung soll insbesondere mit einer kleinen Anzahl von Prozessschritten und insbesondere unter Verwendung weniger lithografischer Masken herstellbar sein. Außerdem soll ein einfaches Herstellungsverfahren für eine integrierte Schaltungsanordnung mit Kondensator angegeben werden.

Die auf die Schaltungsanordnung bezogene Aufgabe wird durch eine integrierte Schaltungsanordnung mit den im Patentanspruch 1 angegebenen Merkmalen sowie durch ein zugehöriges Herstellungsverfahren mit den im Patentanspruch 11 angegebenen Merkmalen gelöst. Weiterbildungen sind in den Unteransprüchen angegeben.

Bei der erfindungsgemäßen Schaltungsanordnung ist der Isolierbereich Bestandteil einer in einer Ebene angeordneten Isolierschicht. Der Kondensator und mindestens ein aktives Bauelement der integrierten Schaltungsanordnung, vorzugsweise alle aktiven Bauelemente der integrierten Schaltungsanordnung, liegen auf der gleichen Seite der Isolierschicht. Außerdem sind der isolierbereichsnahe Elektrodenbereich und der aktive Bereich des Bauelementes in einer Ebene angeordnet, die parallel zu der Ebene liegt, in der die Isolierschicht angeordnet ist.

Die erfindungsgemäße Schaltungsanordnung ist einfach aufgebaut und lässt sich auf einfache Art herstellen, weil sich der isolierbereichsnahe Elektrodenbereich und der aktive Bereich in einer Ebene befinden. Außerdem sind der isolierbereichsnahe Elektrodenbereich und der aktive Bereich durch den Isolierbereich isoliert. An beide Elektrodenbereiche des Kondensators sind so frei wählbare Potentiale anlegbar.

Der Kondensator hat außerdem hervorragende elektronische Eigenschaften:

- Das Verhältnis zwischen parasitären Kapazitäten und Widerständen in Bezug zur Nutzkapazität ist klein,
- die Leckströme sind klein,
- die differenzielle Nichtlinearität der Kapazität ist klein, wobei unterschiedliche differentielle Kapazitäten auf Raumladungszonen zurückzuführen sind. Bei analogen Kapazitäten ist die differentielle Kapazität die im Arbeitspunkt wirksame Kapazität.
- die Kapazität ist über einen weiten Arbeitspunktbereich konstant,
- das erzielbare Kapazitäts-Flächen-Verhältnis ist groß, beispielsweise mehr als zehn Femtofarad je Quadratmikrometer oder sogar größer als zwanzig Femtofarad je Quadratmikrometer.

Außerdem ist zwischen den aktiven Bauelementen und dem Kondensator keine weitere Schicht oder weitere Schichtenfolge erforderlich. Dies ermöglicht es, die Anzahl der erforderlichen Schichten zu verringern und die Planarität der integrierten Schaltungsanordnung zu erhöhen.

Bei einer Weiterbildung ist das aktive Bauelement ein Feldeffekttransistor:

- der Kanalbereich des Feldeffekttransistors ist der aktive Bereich.
- Die Steuerelektrode des Feldeffekttransistors ist Bestandteil einer strukturierten Elektrodenschicht, in der auch der isolierbereichsferne Elektrodenbereich des Kondensators angeordnet ist. Die Steuerelektrode und der isolierbereichsferne Elektrodenbereich bestehen aus dem gleichen Material. Auch die Dicke dieser Bereiche und deren Dotierstoffkonzentration stimmen überein.
- Ein Steuerelektrodenisolationsbereich des Feldeffekttransistors besteht bei einer Ausgestaltung aus dem gleichen Material wie der dielektrische Bereich des Kondensators. Auch die Dicke dieser Bereiche stimmt überein.

Durch diese Maßnahme sind für die Herstellung des Kondensators und zur Herstellung des Feldeffekttransistors nur drei Schichterzeugungsprozesse erforderlich. Die Bereiche des Feldeffekttransistors und des Kondensators, die in der gleichen Schicht liegen, lassen sich gemeinsam strukturieren. Eine zusätzliche Maske zur Herstellung des Kondensators ist nur dann erforderlich, wenn der untere Elektrodenbereich des Kondensators anders dotiert wird als der Kanalbereich des Feldeffekttransistors. Eine weiter zusätzliche Maske ist nur dann erforderlich, wenn sich die Materialien und/oder die

Isolierdicken des Steuerelektrodenisolierbereiches und des dielektrische Bereiches des Kondensators unterscheiden. Aber selbst dann ist die zur Herstellung der Schaltungsanordnung erforderliche Anzahl der Masken noch klein.

Bei einer nächsten Weiterbildung ist der Feldeffekttransistor ein planarer Feldeffekttransistor, d.h. die für die Steuerung der Gateelektrode wirksame Fläche liegt parallel zur Isolierschicht. Der Feldeffekttransistor enthält neben HDD-Anschlussbereichen (Highly Doped Drain) ggf. auch LDD-Anschlussbereiche (Lightly Doped Drain) bzw. Hilfsanschlussbereiche und/oder sogenannte Pockets bzw. Halos, die hier als Hilfsdotierbereiche bezeichnet werden.

Bei einer anderen Ausgestaltung grenzt die Steuerelektrode an einen Silizidbereich an. Durch diese Maßnahme lässt sich die Steuerelektrode leichter kontaktieren. Außerdem verringert sich der Anschlusswiderstand und der Schichtwiderstand.

Bei einer nächsten Weiterbildung der erfindungsgemäßen Schaltungsanordnung grenzen Anschlussbereiche des Feldeffekttransistors an die Isolierschicht an. Bei einer Ausgestaltung grenzen die Anschlussbereiche ebenfalls an Silizidbereiche. Ausreichend Material für die Silizidbildung ist dann vorhanden, wenn die Halbleiterschicht im Bereich der Anschlussbereiche sowohl vor als auch nach der Silizidbildung eine größere Dicke hat als im Bereich der isolierbereichsnahen Elektrode.

Bei einer nächsten Weiterbildung sind beidseitig der Steuerelektrode Abstandshalter angeordnet, die auch ein anderes Material enthalten oder aus einem anderen Material bestehen als die Elektrodenschicht, insbesondere einem Material, das nicht als Ausgangspunkt für ein Epitaxieschichtwachstum bei einem Epitaxieverfahren zum Erzeugen einer Halbleiterepitaxieschicht geeignet ist, beispielsweise aus Siliziumnitrid. Durch die Verwendung der Abstandshalter werden Seitenbereiche der Steuerelektrode bedeckt, so dass von dort keine Epitaxie ausgehen kann und Kurzschlüsse vermieden werden.

Bei einer Ausgestaltung ist an mindestens einer Seite des isolationsbereichsfernen Elektrodenbereiches ebenfalls ein Abstandshalter angeordnet. Die Abstandshalter haben die gleiche Aufgabe wie die an der Steuerelektrode angeordneten Abstandshalter erfüllt. Berühren sich ein am Gate angeordneter Abstandshalter und ein an einer Elektrode des Kondensators angeordneter Abstandshalter, so entsteht eine Maskierung, die bspw. eine Dotierung oder auch eine Silizidierung im maskierten Bereich verhindert.

Bei einer Weiterbildung ist die an den einen Anschlussbereich des Transistors angrenzende Seite des isolierbereichsnahen Elektrodenbereiches länger als eine quer zu dieser Seite liegende Seite des isolierbereichsnahen Elektrodenbereiches, vorzugsweise mindestens doppelt so lang oder mindestens fünf mal so lang. Der Transistor hat in diesem Fall eine Transistorweite, die ein mehrfaches der minimalen Strukturbreite beträgt, vorzugsweise mehr als das Dreifache oder mehr als das Fünffache. Durch diese Maßnahmen entsteht eine besonders niederohmige Verbindung zwischen dem Transistor und dem Kondensator. Dies führt insbesondere bei sogenannten analogen Kapazitäten in analogen Schaltungen zur Verbesserung der elektronischen Eigenschaften. Beispiele für solche analogen Schaltungen sind Analog-Digital-Wandler. Ein anderes Beispiel für eine analoge Kapazität ist eine sogenannte Bypass-Kapazität mit der sich Spannungsspitzen auf eine Betriebsspannungsleitung oder einer Signalleitung glätten lassen.

Bei einer alternativen Weiterbildung ist dagegen eine quer zu der an den Anschlussbereich angrenzende Seite des isolierbereichsnahen Elektrodenbereiches liegende Seite des isolierbereichsnahen Elektrodenbereiches länger als die an den Anschlussbereich angrenzende Seite, vorzugsweise mindestens doppelt so lang oder mindestens fünf mal so lang. Der Transistor hat in diesem Fall eine Transistorweite, die kleiner als das Dreifache der minimalen Strukturbreite ist, vorzugsweise kleiner als das Doppelte der minimalen Strukturbreite. Durch diese Maßnahme wird insbesondere bei Speicherzellen erreicht, dass sich der ohmsche Widerstand der Bodenelektrode des Kondensators erhöht und einer schnellen Entladung der Speicherkapazität damit entgegengewirkt wird.

Bei einer nächsten Weiterbildung grenzen ein Anschlussbereich des Feldeffekttransistors und der isolierbereichsnahe Elektrodenbereich des Kondensators aneinander und bilden so eine elektrisch leitfähige Verbindung. Auf diese Art und Weise entsteht eine einfach aufgebaute Speicherzelle eines DRAM (Dynamic Random Access Memory), ohne dass zusätzliche Maßnahmen für die Kontaktierung der isolierbereichsnahen Bodenelektrode erforderlich sind. Diese Weiterbildung wird insbesondere in Kombination mit sich berührenden Abstandshaltern am Gate und an der Deckelektrode des Kondensators eingesetzt.

Bei einer Weiterbildung sind der isolierbereichsnahe Elektrodenbereich und der aktive Bereich Halbleiterbereiche, die ein Halbleitermaterial enthalten, d.h. ein Material mit einem spezifischen elektrischen Widerstand zwischen $10^{-6}$ und $10^{+12}$ $\Omega$cm, insbesondere zwischen $10^{-5}$ und $10^{+10}$ $\Omega$cm, z.B. Germanium, Silizium oder Galliumarsenid. Der spezifische Widerstand des isolierbereichsnahen Elektrodenbereiches des Kondensators wird bei einer Ausgestaltung durch eine Dotierung verringert.

Bei einer Weiterbildung der Schaltungsanordnung sind der isolierbereichsnahe Elektrodenbereich und der aktive Bereich einkristalline Bereiche, die dotiert oder undotiert sind. Die elektronischen Eigenschaften von aktiven Bauelementen in einkristallinen Schichten sind besonders gut. Außerdem lässt sich der elektrische Widerstand einer einkristallinen Elektrode des Kondensators durch Dotierung besonders gut verringern. Bei einer Ausgestaltung haben der isolierbereichsnahe Elektrodenbereich und der aktive Bereich eine Dicke kleiner als einhundert Nanometer oder sogar kleiner als fünfzig Nanometer.

Bei einer nächsten Weiterbildung grenzt die Isolierschicht an ein Trägersubstrat an, wie es bei einem sogenannten SOI-Substrat (Silicon On Insulator) der Fall ist. Derartige Substrate lassen sich auf einfache Art und Weise herstellen. Außerdem haben die elektronischen Schaltungen, die auf diesen Substraten angeordnet werden, besonders gute elektronische Eigenschaften.

Bei einer anderen Weiterbildung enthält die Schaltungsanordnung mindestens einen Prozessor, der eine Vielzahl von logischen Schaltfunktionen enthält. Enthält die Schaltungsanordnung bei einer Ausgestaltung neben dem Prozessor außerdem eine Vielzahl von DRAM-Speichereinheiten (Dynamic Random Access Memory), so wird auch von einem embedded-Speicher gesprochen. Zur Herstellung dieser Schaltungsanordnung werden zusätzlich zu den für die Herstellung der Logik ohnehin erforderlichen Prozessschritten und Masken nur eine kleine Anzahl von zusätzlichen Prozessschritten und zusätzlichen Masken zur Herstellung des Kondensators bzw. der mit ihm elektrisch leitfähig verbundenen Transistoren benötigt.

Die Erfindung betrifft in einem weiteren Aspekt außerdem ein Verfahren zum Herstellen einer integrierten Schaltungsanordnung, insbesondere zum Herstellen der erfindungsgemäßen Schaltungsanordnung oder einer ihrer Weiterbildungen. Bei dem erfindungsgemäßen Verfahren werden ohne Beschränkung durch die angegebene Reihenfolge die folgenden Verfahrensschritte ausgeführt:

- Bereitstellen eines Substrats, das eine Isolierschicht aus elektrisch isolierendem Material und eine Halbleiterschicht enthält, z.B. ein SOI-Substrat,
- Strukturieren der Halbleiterschicht zum Ausbilden mindestens eines Elektrodenbereiches für einen Kondensator und zum Ausbilden mindestens eines aktiven Bereiches eines Transistors,
- nach dem Strukturieren der Halbleiterschicht Erzeugen einer dielektrischen Schicht,
- nach dem Erzeugen der dielektrischen Schicht Erzeugen einer Elektrodenschicht, und
- Ausbilden einer isolierbereichsfernen Elektrode des Kondensators und einer Steuerelektrode des Transistors in der Elektrodenschicht.

Das erfindungsgemäße Verfahren ist besonders geeignet zur Herstellung eines planaren Feldeffekttransistors gemeinsam mit dem Kondensator. Die oben genannten technischen Wirkungen der erfindungsgemäßen Schaltungsanordnung und ihrer Weiterbildungen gelten auch für das erfindungsgemäße Verfahren und dessen Weiterbildungen.

Im Folgenden werden Ausführungsbeispiele der Erfindung an Hand der beiliegenden Zeichnungen erläutert. Darin zeigen:

Figuren 1 bis 12　　Herstellungsstufen bei der Herstellung einer integrierten Transistor-Kondensator-Anordnung,

Figur 13　　eine Draufsicht auf die Transistor-Kondensator-Anordnung,

Figur 14　　eine Schnittdarstellung durch ein DRAM-Speicherzelle mit einem Transistor,

Figur 15　　eine Draufsicht auf die DRAM-Speicherzelle, und

Figur 16　　einen Schaltplan einer DRAM-Speicherzelle mit drei Transistoren.

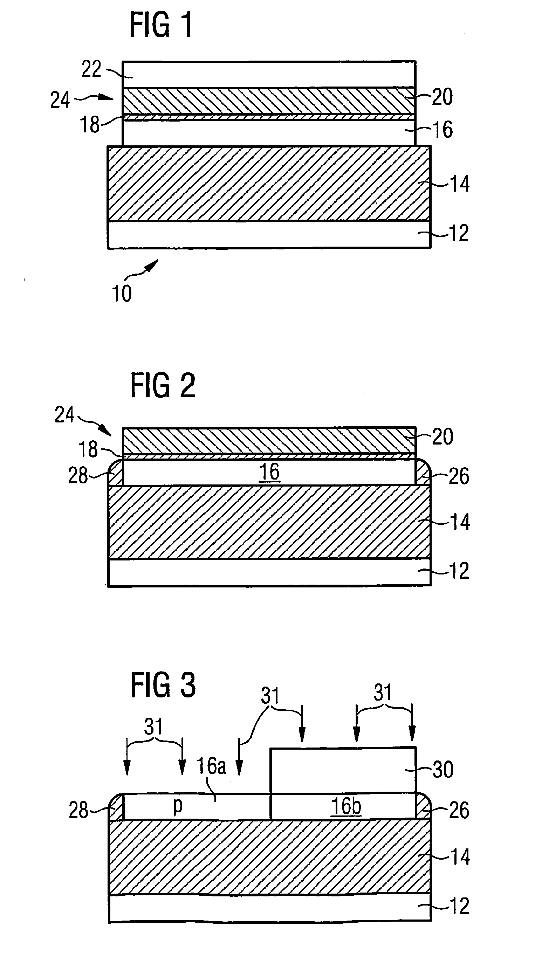

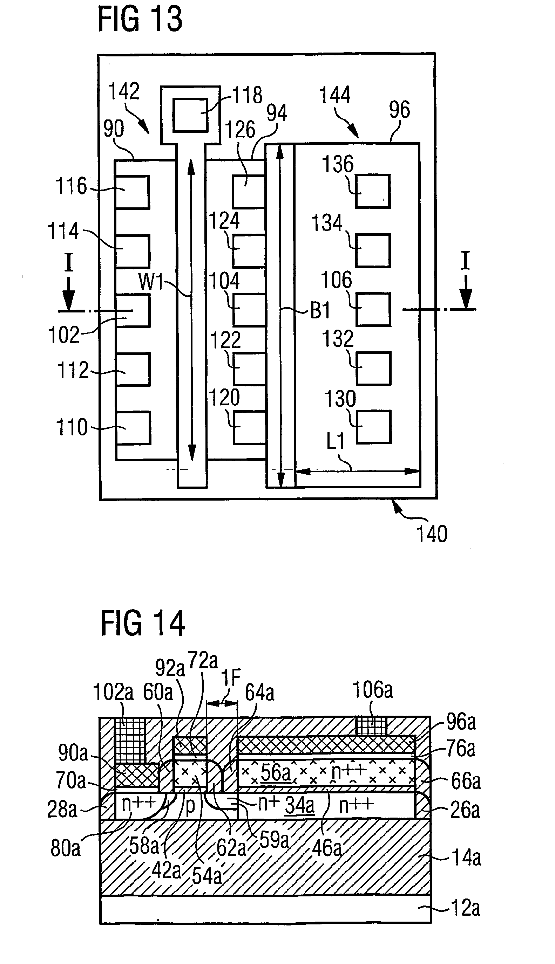

Die Figuren 1 bis 12 zeigen Herstellungsstufen bei der Herstellung einer Transistor-Kondensator-Anordnung, wobei die Figuren 1 bis 12 eine Schnittdarstellung entlang einer Schnittebene I betreffen, die längs zu einem Kanal eines Feldeffekttransistors liegt, insbesondere längs zum Stromfluss im Kanal. Die Lage der Schnittebene I wird aus Figur 13 deutlich.

Die Herstellung der Transistor-Kondensator-Anordnung beginnt ausgehend von einem SOI-Substrat 10, das ein Trägersubstrat 12 aus einkristallinem Silizium, eine sogenannte vergrabene Isolierschicht 14 aus beispielsweise Siliziumdioxid und eine dünne Halbleiterschicht 16 aus monokristallinem Silizium enthält. Im Ausführungsbeispiel betragen die Dicke des Trägersubstrats 12 fünfhundertfünfzig Mikrometer, die Dicke der Isolierschicht 14 einhundert Nanometer und die Dicke der Halbleiterschicht 16 fünfzig Nanometer. Auf der Halbleiterschicht 16 hat sich eine dünne Siliziumdioxidschicht 18 mit einer Dicke von bspw. fünf Nanometern gebildet.

Wie in Figur 1 dargestellt, wird auf das SOI-Substrat 10 eine Siliziumnitridschicht 20 abgeschieden, beispielsweise mit Hilfe eines CVD-Verfahrens (Chemical Vapor Deposition). Im Ausführungsbeispiel hat die Siliziumnitridschicht 20 eine Dicke von fünfzig Nanometern.

Wie in Figur 1 dargestellt, wird anschließend ein Lithografieverfahren durchgeführt. Dazu wird eine Fotolackschicht 22 ganzflächig aufgebracht, gemäß einem vorgegebenen Layout belichtet und entwickelt. Anschließend werden die als Hartmaske dienende Nitridschicht 20, die Siliziumdioxidschicht 18 und die Halbleiterschicht 16 strukturiert, beispielsweise mit einem Trockenätzverfahren. Dabei entsteht ein Schichtstapel 24 mit einer etwa quadratischen Grundfläche. Der Schichtstapel 24 wird auch als Mesa bezeichnet. Die Geometrie für den herzustellenden Feldeffekttransistor und den Kondensator lassen sich unabhängig voneinander vorgeben und somit optimieren.

Alternativ zu einem fotolithografischen Verfahren wird bei einem anderen Ausführungsbeispiel ein Elektronenstrahl-Lithögrafie-Verfahren oder ein anderes geeignetes Verfahren durchgeführt. Bei einem anderen Ausführungsbeispiel wird keine Hartmaske verwendet. Bspw. wird dann die Fotolackschicht 22 dicker aufgetragen.

Wie in Figur 2 dargestellt, werden die verbliebenen Bereiche der Fotolackschicht 22 anschließend entfernt. Nach dem Entfernen der Fotolackschicht 22 wird eine thermische Oxidation ausgeführt. Dabei bilden sich an den Seitenflächen der Halbleiterschicht 16 Verrundungsoxidbereiche 26, 28, die später unerwünschte Kanalbildungen an den Kanten unterdrücken. Alternativ lässt sich zur Isolation ein LOCOS-Verfahren (LOCal Oxidization of Silicon) oder ein STI-Verfahren (Shallow Trench Isolation) in Verbindung mit einem CMP-Verfahren (Chemical Mechanical Polishing) ausführen.

Danach werden die verbliebenen Bereiche der Nitridschicht 20 und der Siliziumdioxidschicht 18 entfernt, bspw. durch Trockenätzen. Für folgende Implantationsschritte lässt sich ein dünnes Streuoxid aufbringen, das in den Figuren jedoch nicht dargestellt ist.

Wie in Figur 3 dargestellt, wird danach zur Herstellung eines nMOSFET eine weitere Fotolackschicht 30 aufgebracht, belichtet und entwickelt, so dass nur das Kanalgebiet und Bereiche für Anschlussgebiete des Transistors unmaskiert sind, siehe Transistorteil 16a der Halbleiterschicht 16. Ein für den Kondensator vorgesehener Bereich ist dagegen maskiert, siehe Kondensatorteil 16b der Halbleiterschicht 16. Nach dem Entwickeln der Fotolackschicht 30 wird eine Ionenimplantation 31 ausgeführt, wobei der Transistorteil p-dotiert wird, z.B. p oder p+.

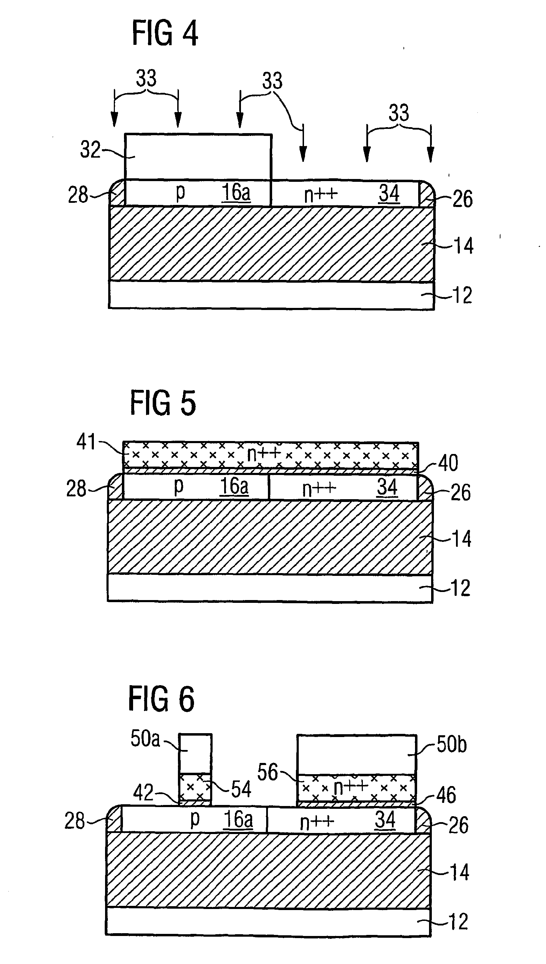

Wie in Figur 4 dargestellt, wird anschließend ein weiteres Fotolithografieverfahren ausgeführt, bei dem eine zusätzliche Maske zur Herstellung des Kondensators erforderlich ist. Es wird eine Fotolackschicht 32 aufgebracht, mit der Maske belichtet und entwickelt, so dass der Transistorteil 16a maskiert und der Kondensatorteil 16b unmaskiert ist.

Anschließend wird unter Verwendung der strukturierten Fotolackschicht 32 eine Ionenimplantation 33 durchgeführt, wobei der Kondensatorteil 16b stark n-dotiert wird, d.h. n++, und ein Bodenelektrodenbereich 34 entsteht. In dem maskierten Transistorteil 16a bleibt die Dotierung während der Ionenimplantation 33 unverändert. Durch die Zusatzimplantation wird der Bodenelektrodenbereich 34 niederohmig. Beispielsweise beträgt die Dotierungsdichte $10^{20}$ Dotieratome je Kubikzentimeter. Die Dotierungsdichte liegt vorzugsweise im Bereich zwischen $10^{19}$ bis $10^{21}$ Dotieratome je Kubikzentimeter. Bei steigender Dotierdichte wächst das Dielektrikum schneller als auf undotierten oder nur mittel stark dotierten Bereichen. Jedoch werden mit steigender Dotierungsdichte die sich ausbildenden Raumladungszonen kleiner, so dass parasitäre Effekte ebenfalls kleiner werden.

Wie in Figur 5 dargestellt, wird anschließend die Fotolackschicht 32 entfernt. An der freiliegenden Fläche des Transistorteils 16a der Halbleiterschicht 16 und an der freiliegenden Fläche des Bodenelektrodenbereiches 34 wird anschließend eine dünne Siliziumdioxidschicht 40 erzeugt, die im Bereich des Transistors ein Gateoxid 42 und im Bereich des Kondensators ein Dielektrikum 46 bildet. Beispielsweise wächst die Siliziumdioxidschicht 40 thermisch auf. Im Ausführungsbeispiel hat die Siliziumdioxidschicht 40 im Bereich des undotierten Siliziums eine Dicke von zwei Nanometern.

Bei einem alternativen Ausführungsbeispiel wird unter Verwendung eines weiteren Lithografieverfahrens auf dem Bodenelektrodenbereich 34 des Kondensators ein Dielektrikum aus einem anderen Material und/oder ein Dielektrikum mit einer anderen Dicke als auf dem Transistorteil 16b der Halbleiterschicht 16 erzeugt.

Wie weiter in Figur 5 weiter dargestellt, wird anschließend in-situ oder nachträglich dotiertes polykristallines Silizium abgeschieden, wobei eine Polysiliziumschicht 41 erzeugt wird. Die Polysiliziumschicht 41 hat beispielsweise eine Dicke von einhundert Nanometern und eine Dotierstoffkonzentration von $10^{21}$ Dotieratomen je Kubikzentimeter.

Die starke Dotierung vom n-Leistungstyp ist wiederum durch das Symbol n++ dargestellt. Als Dotieratome werden beispielsweise Phosphoratome verwendet. An Stelle der Polysiliziumschicht 41 wird bei einem anderen Ausführungsbeispiel ein alternatives gut leitendes Material mit geeigneter Materialaustrittsarbeit verwendet.

Wie in Figur 6 gezeigt, wird anschließend ein weiteres Lithografieverfahren u.a. zur Strukturierung einer Gateelektrode 54 durchgeführt. Dazu wird eine Fotolackschicht aufgebracht, belichtet und entwickelt, wobei Fotolackschichtbereiche 50a und 50b erzeugt werden. Anschließend werden die Polysiliziumschicht 41 und die Siliziumdioxidschicht 40 strukturiert, beispielsweise geätzt. Dabei entsteht unter dem Fotolackschichtbereich 50a ein Gateelektrode 54 und unter dem Fotolackschichtbereich 50b eine Deckelektrode 56. Die Ätzung stoppt auf dem Transistorteil 16a der Halbleiterschicht 16 bzw. auf dem Bodenelektrodenbereich 34.

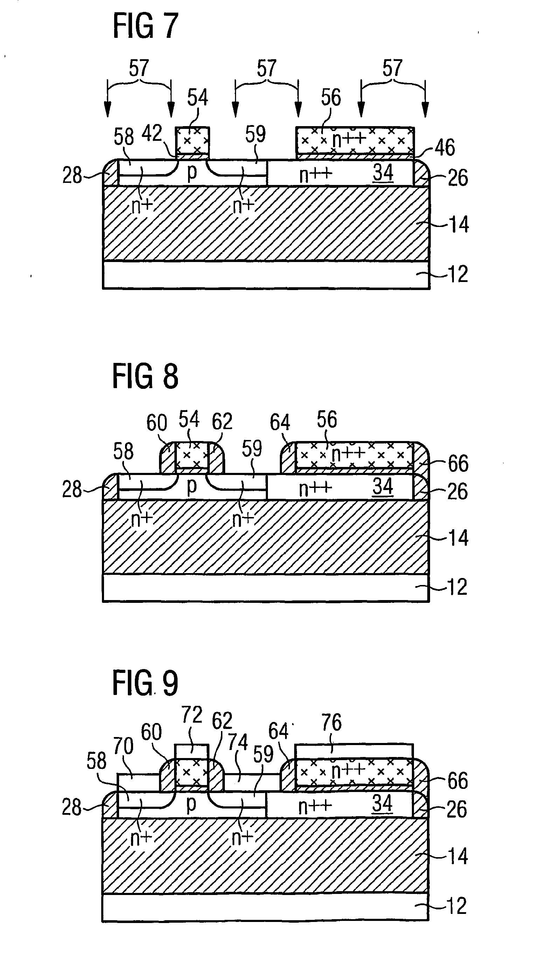

Wie in Figur 7 dargestellt, werden die Fotolackschichtbereiche 50a und 50b nach der Ätzung entfernt. Danach wird eine Ionenimplantation 57 durchgeführt, um schwach dotierte LDD-Bereiche 58 und 59 (Lightly Doped Drain) in oberen Bereichen des Transistorteils 16a der Halbleiterschicht 16 zu erzeugen.

Wie in Figur 8 gezeigt, wird anschließend eine dünne TEOS-Schicht oder Siliziumnitridschicht ganzflächig abgeschieden, beispielsweise mit Hilfe eines CVD-Verfahrens (Chemical Vapor Deposition). Die Siliziumnitridschicht 60 hat im Ausführungsbeispiel eine Dicke von fünfzig Nanometern. Wie weiter in Figur 8 dargestellt, wird die TEOS-Schicht anschließend in einem anisotropen Ätzprozess zu Abstandshaltern 60 und 62 an den Seitenwänden der Gateelektrode 54 sowie zu Abstandshaltern 64 und 66 an den Seitenwänden der Deckelektrode 56 zurückgeätzt. Auf diese Weise werden sowohl die Gateelektrode 54 als auch die Deckelektrode 56 zu allen Seiten hin isoliert. Eine folgende Epitaxie ist an den Seitenflächen der Gateelektrode 54 und der Deckelektrode 56 nicht möglich, so dass Kurzschlüsse vermieden werden.

Wie in Figur 9 dargestellt, wird anschließend ein selektives Epitaxieverfahren durchgeführt. Eine monokristalline Epitaxieschicht wächst auf freiliegenden Flächenabschnitten der LDD-Bereiche 58 und 59 sowie des Bodenelektrodenbereiches 54 auf. Es entstehen Epitaxiebereiche 70 und 74 auf dem monokristallinem Silizium der Halbleiterschicht 16. Die Epitaxiebereiche 70 und 74 erstrecken sich etwa bis zur halben Höhe der Gateelektrode 54 bzw. der Deckelektrode 56. Die Epitaxiebereiche 70 und 74 werden auch als "angehobene" (elevated) Source-/Drain-Bereiche bezeichnet. Die Dicke der Epitaxieschicht für die Epitaxiebereiche 70 und 74 richtet sich vor allem nach der Dicke der Halbleiterschicht 16 und der nachfolgend erläuterten Silizidierung. Bei der Silizidierung wird vorhandenes Silizium verbraucht, so dass entsprechend viel Silizium für die Reaktion bereitgestellt wird. Durch diese Maßnahme wird ein "Abreißen" der Kanalanschlüsse im Bereich des Drain-/Source-Bereiches vermieden. Epitaxiebereiche 72 und 76 liegen auf der Gateelektrode 54 bzw. auf der Deckelektrode 56. Die Epitaxiebereiche 72 und 76 sind nicht vorhanden, wenn alternative Gatematerialien verwendet werden.

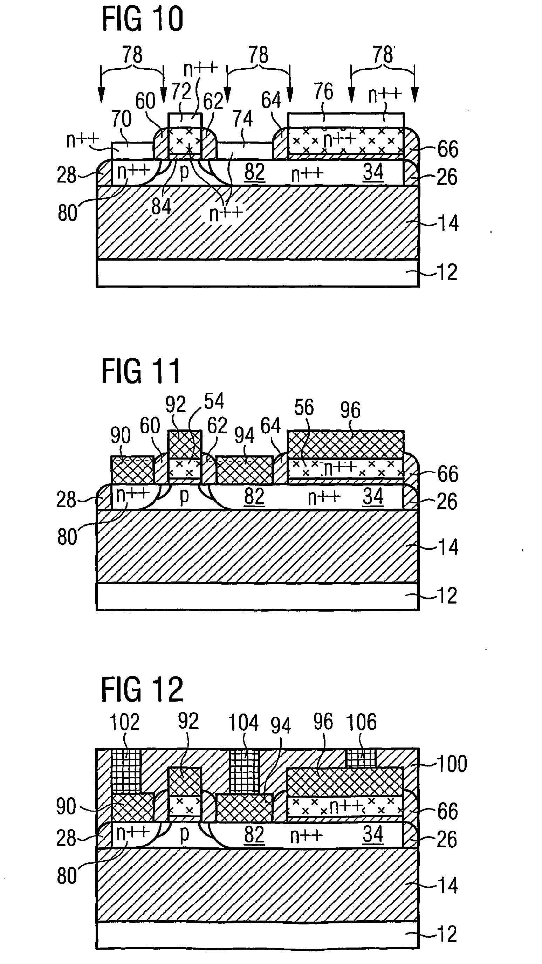

Wie in Figur 10 gezeigt, wird nach dem Epitaxieverfahren eine Ionenimplantation 78, z.B. n++, d.h. stark n-dotiert, zum Herstellen von hochdotierten und damit niederohmigen Source/Drain-Bereiche 80 und 82 durchgeführt. Dabei werden auch die Epitaxiebereiche 70 bis 76 dotiert. Eine Maske ist hier ledigliph zum Trennen von Bereichen mit komplementären Transistoren in einem CMOS-Prozess (Complementary Metal Oxide Semiconductor) erforderlich. Es entsteht eine Verbindung zwischen dem Source-/Drain-Bereich 82 und dem Bodenelektrodenbereich 34 des Kondensators. Ein zwischen den Source-/Drain-Bereichen 80 und 82 in dem Transistorteil 16a der Halbleiterschicht 16 liegender Kanalbereich 84 bleibt p-dotiert. Während der Implantation dienen die Abstandshalter 60 und 62 sowie der Gatestapel als Implantationsmaske.

Wie in Figur 11 dargestellt, wird im Anschluss an die HDD-Implantation (High Density Drain) ein Salicide-Verfahren (Self aligned silicide) durchgeführt. Dazu wird beispielsweise ganzflächig eine Nickelschicht abgeschieden. Bei Temperaturen von beispielsweise 500°C bildet sich Nickelsilizid in den Epitaxiebereichen 70 bis 76 und damit auf den Source/Drainbereichen 80, 82, auf der Gateelektrode 54 und auf der Deckelektrode 56, siehe Silizidbereiche 90 bis 96. An Stelle von Nickel lässt sich auch ein anderes Metall mit einer Schmelztemperatur über 1400 Grad Celsius verwenden, insbesondere ein Refraktärmetall, um bspw. Titansilizid oder Kobaltsilizid herzustellen. Bei dem in Figur 11 gezeigten Ausführungsbeispiel sind die Epitaxiebereiche 70 bis 76 vollständig silizidiert. Die Halbleiterschicht 16 und die Deckelektrode 56 wurden dagegen nicht silizidiert. Bei einem anderen Ausführungsbeispiel werde auch Bereiche der Halbleiterschicht 16 bzw. der Deckelektrode 56 silizidiert

Wie in Figur 12 dargestellt, wird anschließend eine Passivierungsschicht 100 aufgebracht, beispielsweise eine TEOS-Schicht (Tetra Ethyl Ortho Silicate), eine BPSG-Schicht (Bor Phosphorous Silicat Glass) oder eine Schicht aus einem anderen geeigneten Material. In die Passivierungsschicht 100 werden unter Verwendung eines fotolithografischen Verfahrens Kontaktlöcher geätzt und beispielsweise mit Wolfram gefüllt, wobei Verbindungsabschnitte 102, 104 und 106 entstehen, die in dieser Reihenfolge zum Silizidbereich 90, 94 bzw. 96 führen. Die Verbindungsabschnitte 102 bis 106 werden anschließend noch mit Leiterbahnen einer nicht dargestellten Metallisierungslage oder mehrerer Metallisierungslagen verbunden. Dabei wird ein konventioneller CMOS-Prozess ausgeführt, der auch als "Back End" bezeichnet wird.

In den Kontaktlöchern werden in der Regel weitere Zwischenschichten zur besseren Haftung oder als Diffusionsbarriere eingebracht. Diese Zwischenschichten sind in Figur 12 aus Gründen der besseren Übersicht nicht dargestellt.

Beispielsweise bestehen diese Schichten aus Titannitrid.

Die Metallleitbahnen werden bspw. mit einem sogenannten Dual-Damascene-Verfahren hergestellt, bei dem Kupfer in Gräben gefüllt wird. Anschließend wird mit einem chemischmechanischen Polierverfahren (CMP - Chemical Mechanical Polishing) poliert. Jedoch werden auch andere Verfahren eingesetzt, z.B. die Ätzung von Aluminiumschichten.

Figur 13 zeigt eine Draufsicht auf die Transistor-Kondensator-Anordnung 140, die einen planaren SOI-FET 142 und einen Kondensator 144 enthält.

Der Transistor 142 hat eine Transistorweite W1, die etwa dem Zehnfachen der minimalen Strukturbreite F entspricht. auf Grund dieser Transistorweite gibt es neben dem Verbindungsabschnitt 102 vier weitere Verbindungsabschnitte 110 bis 116, die zum Silizidbereich 90 führen. Neben dem Verbindungsabschnitt 104 gibt es ebenfalls vier zusätzliche Verbindungsabschnitte 120 bis 126, die zum Silizitbereich 94 führen. Zum Silizitbereich 96 und damit auch zur Deckelektrode 56 führen neben dem Verbindungsabschnitt 106 vier weitere Verbindungsabschnitte 130 bis 136.

Die Länge L1 des Kondensators 144 ist erheblich kürzer als dessen Breite B1. Im Ausführungsbeispiel entspricht die Breibe B1 etwa der Transistorweite. Die Länge L1 beträgt etwa nur ein drittel der Breite B1. Auf Grund dieser Abmessungen und auf Grund der Vielzahl von Verbindungsabschnitten 102 bis 136 kann der Kondensator 144 sehr schnell umgeladen werden.

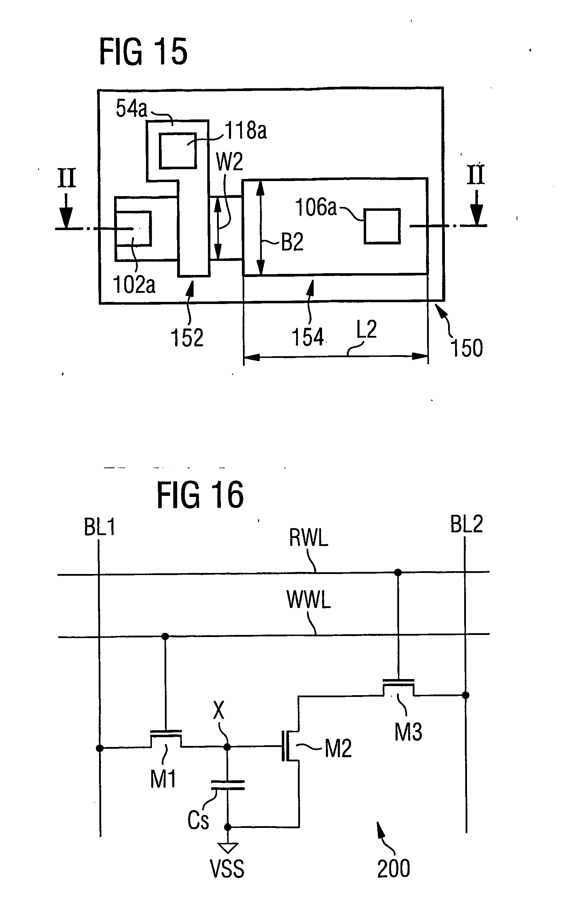

Ein bevorzugter Anwendungsbereich einer Transistor-Kondensator-Anordnung ist eine dynamische Speicherzelle, insbesondere eine sogenannte embedded DRAM-Speicherzelle 150, wie sie in den Figuren 14 und 15 dargestellt ist. Die Speicherzelle 150 enthält nur einen Zugangs-Transistor 152 und einen Kondensator 154. Auch beim Herstellen der Speicherzelle 150 sind die oben an Hand der Figuren 1 bis 12 erläuterten Verfahrensschritte ausgeführt worden. In den Figuren 14 und 15 sind deshalb gleiche Elemente mit gleichen Bezugszeichen jedoch mit einem nachgestellten Kleinbuchstaben a gekennzeichnet.

Somit enthält der planare Feldeffekttransistor 152 u.a.:

- eine Steuerelektrode 54a,
- ein Gateoxid 42a,
- LDD-Bereiche 58a, 59a,
- Anschlussbereiche 80a, 82, und
- Abstandshalter 60a, 62a.

Der Kondensator 154 enthält:

- einen Bodenelektrodenbereich 34a,
- ein Dielektrikum 46a,
- eine Deckelektrode 66a, und
- Abstandshalter 64a.

Epitaxiebereiche 70a, 72a und 76a über dem Anschlussbereich 80a, über der Steuerelektrode 54a bzw. über der Deckelektrode 56a sind nicht vollständig silizidiert worden, so dass Silizidbereiche 90a bis 96a auf diesen Epitaxiebereichen 70a, 72a und 76a angeordnet sind.

Figur 14 zeigt die Speicherzelle 150 in einer Schnittebene II, die in Figur 15 eingetragen ist und die in Längsrichtung des Stromflusses im Kanal des Transistors 152 liegt. Der Abstand zwischen der Deckelektrode 56a und der Gateelektrode 54a wurde auf die minimale Strukturbreite 1 F verringert. Der an der Gateelektrode 54a angeordnete Abstandshalter 62a und der eine an der Deckelektrode 56a angeordnete Abstandshalter 64a berühren einander, so dass das Drain nicht silizidiert ist. Außerdem ist dadurch drainseitig auch nur ein LDD-Bereich 59a aber kein zusätzlicher Anschlussbereich vorhanden. Auch führt zum Drain kein Verbindungsabschnitt. Der LDD-Bereich 59a führt direkt zum Bodenelektrodenbereich 34a. Der so erhöhte Anschlusswiderstand des Bodenelektrodenbereiches 34a wirkt einer Entladung des Kondensators 154 entgegen. Der Entladung des Kondensators 154 wird auch dadurch entgegengewirkt, dass die Breite B2 des Kondensators erheblich kürzer als dessen Länge L2 ist. Auch der geringe Leckstrom des planaren SOI-Transistors 152 verhindert eine schnelle Entladung der Speicherkapazität.

Um eine möglichst hohe Packungsdichte bei minimalem Leckstrom zu erzielen, besitzt der Transistor 152 eine kleine Transistorweite W2 von beispielsweise 1,5 F bis 3 F. Der Kondensator 154 hat die Form eines waagerechten Streifens, dessen Länge L2 durch die erforderliche Mindestspeicherkapazität der Speicherzelle 150 bestimmt wird. Die Transistorweite W2 und die Breite B2 des Kondensators stimmen etwa überein. Beispielsweise ist die Abweichung kleiner als fünfzig Prozent. Der Kondensator 154 ist im Verhältnis zu dem Transistor 152 in den Figuren 13 und 14 verkürzt dargestellt.

Beim Ersatz von mittelgroßen SRAM-Speichereinheiten (Static Random Access Memory) durch einen schnellen embedded-DRAM, beispielsweise im zweiten und dritten Zugriffsniveau einer Mikroprozessorspeicherhierarchie, d.h. im second and third level cache, ergeben sich die folgenden Berechnungen. Beispielsweise hat bisher eine SRAM-Speicherzelle eine Fläche von 134 $F^2$, wobei F die minimale Strukturgröße ist. Wird beispielsweise ein Dielektrikum mit einer Dielektrizitätskonstante er von 3,9 eingesetzt, so lässt sich eine typische embedded-DRAM-Kapazität CMEM von zehn Femtofarad pro Speicherzelle gemäß den folgenden Berechnungen realisieren. Die Oxidkapazität beträgt:

$$COX = \varepsilon r \; \varepsilon 0/tphys = 34,5 \; fF/\mu m^2,$$

wobei tphys die Oxiddicke ist, die im Ausführungsbeispiel ein Nanometer beträgt. Es ergibt sich eine erforderliche Fläche AMEM der Speicherkapazität von:

$$AMEM = CMEM/COX = 0,29 \; \mu m^2.$$

Für eine minimale Strukturbreite F gleich fünfundsechzig Nanometer entspricht dies 69 $F^2$ für die Kapazität bzw. 90 $F^2$ für die gesamte Speicherzelle einschließlich Zugangstransistor. Die Fläche der embedded-DRAM-Speicherzelle liegt damit weit unter der SRAM-Zellgröße von 134 $F^2$.

Bei einer effektiven Oxiddicke von einem Nanometer, einer Korrektur von 0,8 Nanometern für die Gate- und top-Silizium-Verarmung und aufgrund der quantenmechanischen Effekte ergibt sich eine Kapazität pro Fläche von:

$$COX = 3,9 \; \varepsilon 0/tox = 19 \; fF/\mu m^2,$$

wobei tox gleich 1,8 Nanometer die elektrisch wirksame Oxiddicke und $\varepsilon 0$ die Dielektrizitätskonstante im Vakuum bezeichnen. Bei der Verwendung eines Metall-Gates verringert sich die elektrisch wirksame Oxiddicke um etwa 0,4 Nanometer aufgrund der nicht mehr vorhandenen Gate-Verarmung, wodurch sich die Kapazität pro Fläche erhöht auf:

$$COX = 3,9 \; \varepsilon 0/tox = 24 \; fF/\mu m^2.$$

Die erfindungsgemäßen Kapazitäten werden auch als sogenannte Bypass-Kapazitäten zur Dämpfung von sogenannten Spikes und zur Dämpfung von Übersprechen in der Spannungsversorgung der integrierten Schaltungsanordnung verwendet. Auch als analoge Kapazitäten sind sie bestens geeignet, insbesondere in Oszillatoren oder Analog-Digital-Wandlern. Auch für sogenannte Mixed-Signal-Schaltungen werden die Kapazitäten eingesetzt, d.h. für Schaltungen mit analogen Kapazitäten und bspw. Speicherkapazitäten in Speicherzellen.

Bei anderen Ausführungsbeispielen wird an Stelle des Gateoxids ein gesondertes high-K-DRAM-Dielektrikum mit $\varepsilon r$ größer einhundert und effektiven Oxiddicken unter teff gleich 0,1 Nanometer eingesetzt. Beispielsweise ein Dielektrikum, das Bariumstrontiumtitanat (BST) oder Epitaxie-Bariumstrontiumtitanat enthält. Dadurch verringert sich der Flächenbedarf für eine DRAM-Speicherzelle auf ca. 22 $F^2$. Mit Hilfe einer zweiten Zusatzmaske wird der Bereich für das high-K-Dielektrikum auf den SOI-Stapeln festgelegt.

Bei der Erfindung wird eine Kapazität in die FET-Ebene also in das sogenannte top-Silizium auf einem SOI-Substrat integriert. Zur Herstellung der SOI-Kapazität ist nur ein zusätzlicher Prozessschritt erforderlich, wenn das besonders hochqualitative Gatedielektrikum des Transistors als Dielektrikum des Kondensators genutzt wird.

Als weitere Vorteile gegenüber bisherigen Technologiekonzepten ergibt sich ein planarer Übergang zwischen reinen Logikblöcken und embedded-DRAM-Blöcken. Weiterhin werden tiefe Vias und Kontakte vermieden.

Bei dem an Hand der Figuren 1 bis 15 erläuterten Ausführungsbeispielen wurden sowohl eine LDD-Dotierung (Lightly Doped Drain) als auch eine HDD-Dotierung (Highly Doped Drain) durchgeführt. Bei einem anderen Ausführungsbeispiel wird dagegen nur eine HDD-Dotierung aber keine LDD-Dotierung durchgeführt.

Bei einem weiteren Ausführungsbeispiel werden ein Transistor und der Kondensator räumlich weiter voneinander entfernt angeordnet und jeweils mit eigenen Verbindungsabschnitten versehen.

Figur.16 zeigt einen Schaltplan einer DRAM-Speicherzelle 200 (Dynamic Random Access Memory) mit drei Transistoren M1 bis M2 sowie mit einem Kondensator Cs, die mit dem an Hand der Figuren 1 bis 12 erläuterten Verfahrensschritten hergestellt worden sind. Beispielsweise ist der in Figur 14 dargestellte Transistor 152 in einem ersten Fall der Transistor M1. Der Kondensator 154 ist dann der Kondensator Cs. Im ersten Fall führt eine elektrisch leitende Verbindung von einer an den Bodenelektrodenbereich 34a angrenzenden zusätzlichen Anschlussfläche in der Halbleiterschicht 16 zu dem Gate des Transistors M2.

Alternativ wird das Layout in einem zweiten Fall so gewählt, dass der Transistor 152 dem Transistor M2 entspricht, wobei der Kondensator 154 dem Kondensator Cs entspricht. Im zweiten Fall ist die Deckelektrode 56a elektrisch leitend mit dem einen Anschlussbereich des Transistors M1 und mit dem Gate des Transistors M2 verbunden.

Die Schaltung der Speicherzelle 200 enthält eine Teilschaltung zum Schreiben und eine Teilschaltung zum Lesen, wobei beim Lesen die Ladung des Kondensators Cs nicht verändert wird, so dass auch ein Auffrischen dieser Ladung nach einem Lesevorgang nicht erforderlich ist.

Die Teilschaltung zum Schreiben enthält den Schreib-Transistor M1 und den Kondensator Cs. Der Gateanschluss des Transistors M1 ist mit einer Schreibwortleitung WWL verbunden. Der Sourceanschluss des Transistors M1 ist mit einer Schreibbitleitung BL1 verbunden. Bei einer Schaltungsanordnung mit besonders guten elektrischen Eigenschaften gemäß dem oben erwähnten ersten Fall führt der Drainanschluss des Transistors M1 zu einem Speicherknoten X, der durch die Bodenelektrode 34a des Kondensators 154 gebildet wird. Die Deckelektrode 56a des Kondensators Cs bzw. 154 liegt auf einem Massepotential VSS. Bei der Alternative gemäß dem zweiten Fall führt der Drainanschluss des Transistors M1 zu einem Speicherknoten X, der durch die Deckelektrode 56a des Kondensators 154 gebildet wird. Die Bodenelektrode 34a des Kondensators Cs liegt auf einem Massepotential VSS.

Die Teilschaltung zum Lesen enthält die Transistoren M2 und M3. Der Gateanschluss des Transistors M3 ist mit einer Lesewortleitung RWL verbunden. Der Drainanschluss des Transistors M3 ist mit einer Lesebitleitung BL2 verbunden, die vor Beginn des Lesevorganges bspw. auf ein Betriebspotential VDD aufgeladen wird. Der Sourceanschluss des Transistors M3 ist mit dem einen Drainanschluss des Transistors M2 verbunden. Der Gateanschluss des Transistors M2 ist mit dem Speicherknoten X verbunden. Der Sourceanschluss des Transistors M2 liegt auf dem Massepotential VSS.

Der Transistor M2 übernimmt die Aufgabe eines Verstärkers, so dass auch bei Ladungsverlusten auf dem Speicherknoten X noch ein zuverlässiges Lesen möglich ist. Befindet sich eine positive Ladung auf dem Speicherknoten X, so ist der Transistor M2 im eingeschalteten Zustand und die vorgeladene Lesebitleitung BL2 wird beim Lesevorgang entladen.

Da die Gate-Source-Kapazität des Transistors M2 parallel zum Kondensator Cs liegt, erhöht sich die effektiv wirksame Speicherkapazität Ceff:

$$Ceff = Cs + CGS(M2),$$

wobei Cs die Kapazität des Kondensators Cs und CGS die Gate-Source-Kapazität des Transistors M2 sind. Auf Grund des Herstellungsverfahrens sind die Kapazitäten pro Fläche des Speicher-Kondensators Cs und des Transistors M2 bspw. gleich groß, wenn das Gateoxid und das Kondensatordielektrikum in derselben dielektrischen Schicht erzeugt werden und die Schicht überall die gleiche Schichtdicke hat.

Der Flächenbedarf der Speicherzelle 200 wird durch die Anforderungen an die effektiv wirksame Speicherkapazität Ceff bestimmt. Bei geringen Leckströmen und einer hohen Transistorverstärkung, die einen hohen Lesestrom zur Folge hat, lässt sich der Speicher-Kondensator Cs verkleinern. Die für den Kondensator Cs erforderliche Fläche und dessen elektrische Eigenschaften sind Hauptkriterien für die wirtschaftliche Herstellung einer Speichereinheit mit einer Vielzahl von Speicherzellen 200. Auch eine Speichereinheit mit einer Vielzahl von Speicherzellen 200 ist zum Ersetzen eines SRAMS in einer Prozessorspeicherhierarchie geeignet.

**Patentansprüche**

1. Integrierte Schaltungsanordnung (140),
   mit einem elektrisch isolierenden Isolierbereich,
   und mit mindestens einer einen Kondensator (144) bildenden Bereichsfolge, die in der angegebenen Reihenfolge enthält:

   einen isolierbereichsnahen Elektrodenbereich (34),
   einen dielektrischen Bereich (46), und
   einen isolierbereichsfernen Elektrodenbereich (56),

   wobei der Isolierbereich Bestandteil einer in einer Ebene angeordneten Isolierschicht (14) ist,
   wobei der Kondensator (144) und mindestens ein aktives Bauelement (142) der integrierten Schaltungsanordnung (140) auf der gleichen Seite der Isolierschicht (14) angeordnet sind,
   wobei der isolierbereichsnahe Elektrodenbereich (34) und der aktive Bereich (84) des Bauelementes (142) in einer Ebene angeordnet sind, die parallel zu der Ebene liegt, in der die Isolierschicht (14) angeordnet ist,
   und wobei der Kondensator (154) und das aktive Bauelement (152) eine Speicherzelle (150) bilden,

**dadurch gekennzeichnet, dass** der aktive Bereich (84) ein einkristalliner Bereich ist,
und dass mindestens ein Mikroprozessor in der integrierten Schaltungsanordnung enthalten ist.

2. Schaltungsanordnung (140) nach Anspruch 1, **gekennzeichnet durch** mindestens einen Feldeffekttransistor (142),
dessen Kanalbereich (84) der aktive Bereich ist,
wobei der Kanalbereich (84) vorzugsweise dotiert oder undotiert ist,
und/oder dessen Steuerelektrode (54) das gleiche Material und/oder Material der gleichen Dotierstoffkonzentration wie der isolierbereichsferne Elektrodenbereich (56) enthält, und/oder dessen Steuerelektrodenisolationsbereich (42) das gleiche Material und/oder ein Material mit der gleichen Dicke wie der dielektrische Bereich (46) enthält,
und/oder dessen der Steuerelektrodenisolationsbereich (42) ein anderes Material und/oder ein Material mit einer anderen Dicke als der dielektrische Bereich (46) enthält.

3. Schaltungsanordnung (140) nach Anspruch 2, **dadurch gekennzeichnet , dass** der Feldeffekttransistor (122) ein planarer Feldeffekttransistor ist,
und/oder dass der Transistor Hilfsanschlussgebiete (58, 59) enthält, die eine Dotierung mit dem gleichem Leitungstyp wie die Anschlussgebiete (80, 82) jedoch mit einer um mindestens eine Größenordnung kleineren Dotierstoffkonzentration haben, und/oder dass der Transistor Hilfsdotiergebiete enthält, die nahe der Anschlussgebiete (80, 82) und/oder nahe der Hilfsanschlussgebiete (58, 59) angeordnet sind und die eine Dotierung mit einem anderen Leitungstyp als die Anschlussgebiete (80, 82) und/oder als die Hilfsanschlussgebiete (58, 59) haben,
und/oder dass die Steuerelektrode (54) an einen eine Metallhalbleiterverbindung enthaltenden Bereich angrenzt, insbesondere an einen Silizidbereich (92).

4. Schaltungsanordnung (140) nach Anspruch 2 oder 3, **dadurch gekennzeichnet, dass** ein Anschlussbereich (80, 82) des Transistors (142) oder beide Anschlussbereiche (80, 82) des Transistors (142) an die Isolierschicht (14) grenzen,
und/oder dass mindestens ein Anschlussbereich (80, 82) an einen eine Metallhalbleiterverbindung enthaltenden Bereich angrenzt, vorzugsweise an einen Silizidbereiche (90, 96), und/oder dass eine isolierbereichsferne Grenzfläche mindestens eines Anschlussbereiches (80, 82) von der Isolierschicht (14) weiter entfernt ist als der aktive Bereich (84) oder dass eine isolierbereichsferne Grenzfläche mindestens eines Anschlussbereiches (80, 82) näher an der Isolierschicht (14) angeordnet ist als eine isolierbereichsferne Grenzfläche des aktiven Bereiches (84).

5. Schaltungsanordnung (140) nach einem der Ansprüche 2 bis 4, **dadurch gekennzeichnet, dass** beidseitig der Steuerelektrode. (54) Abstandshalter (60, 62) angeordnet sind, die ein anderes Material enthalten als die Steuerelektrode (54), vorzugsweise Siliziumdioxid oder Siliziumnitrid, oder die aus einem anderen Material bestehen als die Steuerelektrode (54), vorzugsweise aus Siliziumdioxid oder aus Siliziumnitrid,
und/oder dass an mindestens einer Seite des isolierbereichsfernen Elektrodenbereiches (56) ein Abstandshalter (64, 66) angeordnet ist, der ein anderes Material enthält als der isolierbereichsferne Elektrodenbereich (56), vorzugsweise Siliziumdioxid oder Siliziumnitrid, oder der aus einem anderen Material besteht als der isolierbereichsferne Elektrodenbereich (56), vorzugsweise aus Siliziumdioxid oder aus Siliziumnitrid,
und/oder dass sich ein an der Steuerelektrode (54) angeordneter Abstandshalter (62a) und ein an dem isolierbereichsfernen Elektrodenbereich (56) angeordneter Abstandshalter (64a) berühren.

6. Schaltungsanordnung (140) nach einem der Ansprüche 2 bis 5, **dadurch gekennzeichnet, dass** ein Anschlussbereich (82) des Feldeffekttransistors (142) und der isolierbereichsnahe Elektrodenbereich (34) des Kondensators (144) aneinander grenzen und eine elektrisch leitfähige Verbindung an der Grenze haben,
und/oder das der an den isolierbereichsnahen Elektrodenbereich (34) angrenzende Anschlussbereich (59a) des Transistors (152) nicht an einen eine Metallhalbleiterverbindung enthaltenden Bereich angrenzt, insbesondere an keinen Silizidbereich,
und/oder dass der andere Anschlussbereich (80a) an einen eine Metallhalbleiterverbindung enthaltenden Bereich (70a) angrenzt.

7. Schaltungsanordnung (140) nach Anspruch 6, **dadurch gekennzeichnet, dass** die an den Anschlussbereich (82) angrenzende Seite des isolierbereichsnahen Elektrodenbereiches (34) länger ist als eine quer zu dieser Seite liegende Seite des isolierbereichsnahen Elektrodenbereiches (34), vorzugsweise mindestens doppelt so lang oder mindestens fünf mal so lang,
wobei der Transistor (142) vorzugsweise eine Transistorweite (W1) hat, die ein mehrfaches der minimalen Strukturbreite (F) beträgt, vorzugsweise mehr als das Dreifache oder mehr als das Fünffache,
oder dass eine quer zu der an den Anschlussbereich (82) angrenzende Seite des isolierbereichsnahen Elektrodenbereiches (34) liegende Seite des isolierbereichsnahen Elektrodenbereiches (34) länger als die an den Anschlussbereich (82) angrenzende Seite ist, vorzugsweise mindestens doppelt so lang oder mindestens fünf mal so lang, wobei der Transistor (152) vorzugsweise eine Transistorweite (W2) hat, die kleiner als das Dreifache der minimalen Strukturbreite (F) ist, vorzugsweise kleiner als das Doppelte der minimalen Strukturbreite (F).

8. Schaltungsanordnung (.140) nach einem der vorhergehenden Ansprüche, **dadurch gekennzeichnet, dass** der isolierbereichsnahe Elektrodenbereich (34) ein einkristalliner Bereich ist, vorzugsweise ein dotierter Halbleiterbereich,
und/oder dass der isolierbereichsnahe Elektrodenbereich (34) und/oder der aktive Bereich (84) eine Dicke kleiner als einhundert Nanometer oder kleiner als fünfzig Nanometer hat, und/oder dass der aktive Bereich (84) ein Halbleiterbereich ist, der dotiert oder undotiert ist,
und/oder dass die Isolierschicht (14) an einer Seite an ein Trägersubstrat (12) angrenzt, vorzugsweise an ein Trägersubstrat, das ein Halbleitermaterial enthält oder aus einem Halbleitermaterial besteht, insbesondere aus Silizium oder aus einkristallinem Silizium,
und/oder dass die Isolierschicht (14) an der anderen Seite an
den isolierbereichsnahen Elektrodenbereich (34) angrenzt, und/oder dass die Grenzflächen vorzugsweise vollständig in zwei zueinander parallelen Ebenen liegen,
und/oder dass die Isolierschicht (14) ein elektrisch isolierendes Material enthält, vorzugsweise ein Oxid, insbesondere Siliziumdioxid, oder aus einem elektrisch isolierenden Material besteht, vorzugsweise aus einem Oxid, insbesondere aus Siliziumdioxid,
und/oder dass das aktive Bauelement (142) ein Transistor ist, vorzugsweise ein Feldeffekttransistor, insbesondere ein planarer Feldeffekttransistor.

9. Schaltungsanordnung (140) nach einem der vorhergehenden Ansprüche, **dadurch gekennzeichnet, dass** der dielektrische Bereich (46) Siliziumdioxid enthält oder aus Siliziumdioxid besteht,
und/oder dass der dielektrische Bereich (46) aus einem Material mit einer Dielektrizitätskonstante größer als vier oder größer als zehn oder größer als fünfzig besteht,
und/oder dass der isolierbereichsferne Elektrodenbereich (56) Silizium enthält, vorzugsweise polykristallines Silizium, oder aus Silizium besteht, vorzugsweise aus polykristallinem Silizium,
und/oder dass der isolierbereichsferne Elektrodenbereich (56) ein Metall enthält oder aus einem Metall besteht,
und/oder dass der isolierbereichsferne Elektrodenbereich (56) ein niederohmiges Material enthält, vorzugsweise Titannitrid, Tantalnitrid, Rubidium oder hochdotiertes Siliziumgermanium, und/oder dass der isolierbereichsferne Elektrodenbereich (56) an einen Metallhalbleiterverbindungen enthaltenden Bereich angrenzt, insbesondere an einen Silizidbereich (96).

10. Schaltungsanordnung (140) nach einem der vorhergehenden Ansprüche, **dadurch gekennzeichnet, dass** der Kondensator (154) und das aktive Bauelement (152) eine Speicherzelle (150) in einer dynamischen RAM-Speichereinheit bilden,
und/oder dass eine Speicherzelle entweder einen Kondensator (152) und nur einen Transistor (152) oder einen Kondensator (Cs) und mehr als einen Transistor (M1 bis M3) enthält, vorzugsweise drei Transistoren (M1 bis M3).

11. Verfahren zum Herstellen einer integrierten Schaltungsanordnung (140) mit Kondensator (144) in einer Schaltungsanordnung (140) nach einem der vorhergehenden Ansprüche, bei dem ohne Beschränkung durch die angegebene Reihenfolge die folgenden Verfahrensschritte ausgeführt werden:

Bereitstellen eines Substrats (10), das eine Isolierschicht (14) aus elektrisch isolierendem Material und eine Halbleiterschicht (16) enthält,
Strukturieren der Halbleiterschicht (16) zur Ausbildung mindestens eines Elektrodenbereiches (34) für einen Kondensator und zur Ausbildung mindestens eines aktiven Bereiches (84) für einen Transistor (142), wobei der aktive Bereich (84) ein einkristalliner Bereich ist,
nach dem Strukturieren der Halbleiterschicht (16) Erzeugen mindestens einer dielektrischen Schicht (42, 46),
nach dem Erzeugen der dielektrischen Schicht (42, 46) Erzeugen einer Elektrodenschicht (41),
Ausbilden einer isolierbereichsfernen Elektrode (56) des Kondensators (144) in der Elektrodenschicht (41).

12. Verfahren nach Anspruch 11, **gekennzeichnet durch** die Schritte:

Aufbringen mindestens einer Hilfsschicht (18, 20) auf die Halbleiterschicht (16) vor dem Strukturieren, vorzugsweise einer Siliziumnitridschicht (20) und/oder einer Oxidschicht (18), wobei die Hilfsschicht (20) vorzugsweise als Hartmaske beim Strukturieren der Halbleiterschicht (16) dient,
und/oder Dotieren eines Kanalbereiches (84) des Transistors (142), vorzugsweise vor dem Erzeugen der dielektrischen Schicht (42, 46),
Durchführen einer thermischen Oxidation zur Bildung eines Verrundungsoxides (26, 28), vorzugsweise vor dem Ausbilden der Elektrodenschicht (41),
und/oder Dotieren der isolierbereichsnahen Elektrode (34), vorzugsweise vor dem Erzeugen der dielelektrischen Schicht (42, 44, 46),
und/oder Erzeugen der dielektrischen Schicht (42, 46) gleichzeitig mit einer dielektrischen Schicht am aktiven Bereich (84) des Transistors (122),
und/oder Ausbilden einer Steuerelektrode (54) des Transistors (142) gleichzeitig mit dem Ausbilden des isolierbereichsfernen Elektrodenbereiches (56).

**13.** Verfahren nach Anspruch 11 oder 12, **gekennzeichnet durch** die Schritte:

Ausbilden von Hilfsanschlussbereichen (58, 59) mit einer kleineren Dotierstoffkonzentration als Anschlussbereiche (80, 82) des Transistors (142), vorzugsweise nach dem Strukturieren einer Steuerelektrode (54) des Transistors (142), und/oder Ausbilden von Hilfsdotiergebieten, vorzugsweise vor der Strukturierung der Steuerelektrode (54),
Aufbringen einer weiteren Hilfsschicht (60 bis 66) nach dem Strukturieren einer Steuerelektrode (54) des Transistors (142), vorzugsweise einer Siliziumnitridschicht oder einer Siliziumdioxidschicht, insbesondere einer TEOS-Schicht, und/oder anisotropes Ätzen der weiteren Hilfsschicht (60 bis 66).

**14.** Verfahren nach einem der Ansprüche 11 bis 13, **gekennzeichnet durch** die Schritte:

Durchführen einer selektiven Epitaxie auf freiliegenden Bereichen aus Halbleitermaterial (16) nach dem Ausbilden des isolierbereichsfernen Elektrodenbereiches (56) und/oder nach dem Strukturieren einer Steuerelektrode (54) des Transistors (142),
und/oder Dotieren von Anschlussbereichen (70, 72) des Transistors (122) nach dem Ausbilden des isolierbereichsfernen Elektrodenbereiches (56) und/oder nach dem Strukturieren der Steuerelektrode (54) und vorzugsweise nach der Epitaxie.

**15.** Verfahren nach einem der Ansprüche 11 bis 14, **gekennzeichnet durch** den Schritt:

und/oder selektive Bildung einer Metallhalbleiterverbindung, insbesondere selektive Silizidbildung, auf der Elektrodenschicht (54) und/oder auf freiliegenden Halbleiterbereichen (16).

**Claims**

**1.** Integrated circuit arrangement (140),
having an electrically insulating insulating region,
and having at least one sequence of regions which forms a capacitor (144) and which contains, in the order specified:

an electrode region (34) near the insulating region, a dielectric region (46), and
an electrode region (56) remote from the insulating region,
the insulating region being part of an insulating layer (14) arranged in a plane,
the capacitor (144) and at least one active component (142) of the integrated circuit arrangement (140) being arranged on the same side of the insulating layer (14), the electrode region (34) near the insulating region and the active region (84) of the component (142) being arranged in a plane which lies parallel to the plane in which the insulating layer (14) is arranged,
and the capacitor (154) and the active component (152) forming a memory cell (150),

**characterized in that** the active region (84) is a monocrystalline region, and **in that** at least one microprocessor is contained in the integrated circuit arrangement.

**2.** Circuit arrangement (140) according to Claim 1, **characterized by** at least one field-effect transistor (142), whose channel region (84) is the active region, the channel region (84) preferably being doped or undoped,
and/or whose control electrode (54) contains the same material and/or material of the same dopant concentration as the electrode region (56) remote from the insulating region,
and/or whose control electrode insulating region (42) contains the same material and/or a material having the same thickness as the dielectric region (46),
and/or whose control electrode insulation region (42) contains a different material and/or a material having a different thickness than the dielectric region (46).

3. Circuit arrangement (140) according to Claim 2,
   **characterized in that** the field-effect transistor (122) is a planar field-effect transistor,
   and/or **in that** the transistor contains auxiliary terminal regions (58, 59), which have a doping with the same conduction type as the terminal regions (80, 82) but with a dopant concentration that is smaller by at least one order of magnitude,
   and/or **in that** the transistor contains auxiliary doping regions, which are arranged near the terminal regions (80, 82) and/or near the auxiliary terminal regions (58, 59) and which have a doping with a different conduction type than the terminal regions (80, 82) and/or than the auxiliary terminal regions (58, 59),
   and/or **in that** the control electrode (54) adjoins a region containing a metal-semiconductor compound, in particular a silicide region (92).

4. Circuit arrangement (140) according to Claim 2 or 3, **characterized in that** one terminal region (80, 82) of the transistor (142) or both terminal regions (80, 82) of the transistor (142) adjoin the insulating layer (14),
   and/or **in that** at least one terminal region (80, 82) adjoins a region containing a metal-semiconductor compound, preferably a silicide region (90, 96),
   and/or **in that** a boundary area of at least one terminal region (80, 82) which is remote from the insulating region is further away from the insulating layer (14) than the active region (84), or
   **in that** a boundary area of at least one terminal region (80, 82) which is remote from the insulating region is arranged nearer to the insulating layer (14) than a boundary area of the active region (84) which is remote from the insulating region.

5. Circuit arrangement (140) according to one of Claims 2 to 4, **characterized in that** spacers (60, 62) are arranged on both sides of the control electrode (54), which spacers contain a different material than the control electrode (54), preferably silicon dioxide or silicon nitride, or which spacers comprise a different material than the control electrode (54), preferably silicon dioxide or silicon nitride,
   and/or **in that** a spacer (64, 66) is arranged at at least one side of the electrode region (56) remote from the insulating region, which spacer contains a different material than the electrode region (56) remote from the insulating region, preferably silicon dioxide or silicon nitride, or which spacer comprises a different material than the electrode region (56) remote from the insulating region, preferably silicon dioxide or silicon nitride,
   and/or **in that** a spacer (62a) arranged at the control electrode (54) and a spacer (64a) arranged at the electrode region (56) remote from the insulating region touch one another.

6. Circuit arrangement (140) according to one of Claims 2 to 5, **characterized in that** a terminal region (82) of the field-effect transistor (142) and the electrode region (34) of the capacitor (144) which is near the insulating region adjoin one another and have an electrically conductive connection at the boundary, and/or **in that** the terminal region (59a) of the transistor (152) which adjoins the electrode region (34) near the insulating region does not adjoin a region containing a metal-semiconductor compound, in particular does not adjoin a silicide region,
   and/or **in that** the other terminal region (80a) adjoins a region (70a) containing a metal-semiconductor compound.

7. Circuit arrangement (140) according to Claim 6, **characterized in that** that side of the electrode region (34) near the insulating region which adjoins the terminal region (82) is longer than a side of the electrode region (34) near the insulating region which lies transversely with respect to said side, preferably being at least twice as long or at least five times as long,
   the transistor (142) preferably having a transistor width (W1) which is a multiple of the minimum feature size (F), preferably more than three-fold or more than five-fold,
   or **in that** a side of the electrode region (34) near the insulating region which lies transversely with respect to that side of the electrode region (34) near the insulating region which adjoins the terminal region (82) is longer than the side adjoining the terminal region (82), preferably at least twice as long or at least five times as long,
   the transistor (152) preferably having a transistor width (W2) which is less than three times the minimum feature size (F), preferably less than twice the minimum feature size (F).

8. Circuit arrangement (140) according to one of the preceding claims, **characterized in that** the electrode region (34) near the insulating region is a monocrystalline region, preferably a doped semiconductor region,

and/or **in that** the electrode region (34) near the insulating region and/or the active region (84) has a thickness of less than 100 nanometers or less than 50 nanometers,

and/or **in that** the active region (84) is a semiconductor region which is doped or undoped,

and/or **in that** the insulating layer (14) adjoins, at one side, a carrier substrate (12), preferably a carrier substrate which contains a semiconductor material or comprises a semiconductor material in particular silicon or monocrystalline silicon,

and/or **in that** the insulating layer (14) adjoins the electrode region (34) near the insulating region at the other side,

and/or **in that** the boundary areas preferably lie completely in two mutually parallel planes,

and/or **in that** the insulating layer (14) contains an electrically insulating material, preferably an oxide, in particular silicon dioxide, or comprises an electrically insulating material, preferably an oxide, in particular silicon dioxide,

and/or **in that** the active component (142) is a transistor, preferably a field-effect transistor, in particular a planar field-effect transistor.

9. Circuit arrangement (140) according to one of the preceding claims, **characterized in that** the dielectric region (46) contains silicon dioxide or comprises silicon dioxide,

and/or **in that** the dielectric region (46) comprises a material having a dielectric constant of greater than 4 or greater than 10 or greater than 50,

and/or **in that** the electrode region (56) remote from the insulating region contains silicon, preferably polycrystalline silicon, or comprises silicon, preferably polycrystalline silicon,

and/or **in that** the electrode region (56) remote from the insulating region contains a metal or comprises a metal,

and/or **in that** the electrode region (56) remote from the insulating region contains a low-impedance material, preferably titanium nitride, tantalum nitride, rubidium or highly doped silicon-germanium,

and/or **in that** the electrode region (56) remote from the insulating region adjoins a region containing metal-semiconductor compounds, in particular a silicide region (96).

10. Circuit arrangement (140) according to one of the preceding claims, **characterized in that** the capacitor (154) and the active component (152) form a memory cell (150) in a dynamic RAM memory unit,

and/or **in that** a memory cell contains either a capacitor (152) and only one transistor (152) or a capacitor (Cs) and more than one transistor (M1 to M3), preferably three transistors (M1 to M3).

11. Method for fabricating an integrated circuit arrangement (140) with a capacitor (144) in a circuit arrangement (140) according to one of the preceding claims,

in which the following method steps are performed without any restriction by the order specified:

provision of a substrate (10) containing an insulating layer (14) made of electrically insulating material and a semiconductor layer (16),

patterning of the semiconductor layer (16) in order to form at least one electrode region (34) for a capacitor and in order to form at least one active region (84) for a transistor (142), the active region (84) being a monocrystalline region,

after the patterning of the semiconductor layer (16) production of at least one dielectric layer (42, 46),

after the production of the dielectric layer (42, 46) production of an electrode layer (41),

formation of an electrode (56) of the capacitor (144) which is remote from the insulating region in the electrode layer (41).

12. Method according to Claim 11, **characterized by** the following steps:

application of at least one auxiliary layer (18, 20) to the semiconductor layer (16) prior to patterning, preferably a silicon nitride layer (20) and/or an oxide layer (18), the auxiliary layer (20) preferably serving as a hard mask during the patterning of the semiconductor layer (16),

and/or doping of a channel region (84) of the transistor (142), preferably before the production of the dielectric layer (42, 46),

carrying out of a thermal oxidation in order to form a rounding oxide (26, 28), preferably before the formation of the electrode layer (41),

and/or doping of the electrode (34) near the insulating region, preferably before the production of the dielectric layer (42, 44, 46),

and/or production of the dielectric layer (42, 46) at the same time as a dielectric layer at the active region (84) of the transistor (122),

and/or formation of a control electrode (54) of the transistor (142) at the same time as the formation of the electrode region (56) remote from the insulating region.

13. Method according to Claim 11 or 12, **characterized by** the following steps:

formation of auxiliary terminal regions (58, 59) with a lower dopant concentration than terminal regions (80, 82) of the transistor (142), preferably after the patterning of a control electrode (54) of the transistor (142), and/or formation of auxiliary doping regions, preferably before the patterning of the control electrode (54), application of a further auxiliary layer (60 to 66) after the patterning of a control electrode (54) of the transistor (142), preferably a silicon nitride layer or a silicon dioxide layer, in particular a TEOS layer, and/or anisotropic etching of the further auxiliary layer (60 to 66).

14. Method according to one of Claims 11 to 13, **characterized by** the following steps:

carrying out of a selective epitaxy on uncovered regions made of semiconductor material (16) after the formation of the electrode region (56) remote from the insulating region and/or after the patterning of a control electrode (54) of the transistor (142), and/or doping of terminal regions (70, 72) of the transistor (122) after the formation of the electrode region (56) remote from the insulating region and/or after the patterning of the control electrode (54) and preferably after the epitaxy.

15. Method according to one of Claims 11 to 14, **characterized by** the following step:

and/or selective formation of a metal-semiconductor compound, in particular selective silicide formation, on the electrode layer (54) and/or on uncovered semiconductor regions (16).

**Revendications**

1. Circuit (140) intégré, comprenant une zone d'isolation, isolante du point de vue électrique et comprenant au moins une succession de zones, formant un condensateur (144) et comportant dans l'ordre indiqué :

une zone (34) d'électrode proche de la zone d'isolation, une zone (46) diélectrique, et une zone (56) d'électrode éloignée de la zone d'isolation,

dans lequel la zone d'isolation fait partie d'une couche (14) d'isolation disposée dans un plan, dans lequel le condensateur (144) et au moins un composant (142) actif du circuit (140) intégré sont disposés du même côté de la couche (14) d'isolation, dans lequel la zone (34) d'électrode proche de la zone d'isolation et la zone (84) active du composant (142) sont disposées dans un plan qui est parallèle au plan dans lequel est disposée la couche (14) d'isolation, et dans lequel le condensateur (154) et le composant (152) actif forment une cellule (150) de mémoire, **caractérisé en ce que** la zone (84) active est une zone monocristalline, et **en ce qu'**au moins un microprocesseur est contenu dans le circuit intégré.

2. Circuit (140) suivant la revendication 1, **caractérisé par** au moins un transistor (142) à effet de champ dont la zone (84) de canal est la zone active, la zone (84) de canal étant, de préférence, dopée ou ne l'étant pas, et/ou dont l'électrode (54) de commande contient le même matériau et/ou du matériau de la même concentration de substance de dopage que la zone (56) d'électrode éloignée de la zone d'isolation, et/ou dont la zone (42) d'isolation de l'électrode de commande contient le même matériau et/ou un matériau ayant la même épaisseur que la zone (46) diélectrique, et/ou dont la zone (42) d'isolation de l'électrode de commande contient un matériau autre et/ou un matériau ayant une autre épaisseur que la zone (46) diélectrique.

3. Circuit (140) suivant la revendication 2, **caractérisé en ce que** le transistor (122) à effet de champ est un transistor à effet de champ planaire, et/ou **en ce que** le transistor comporte des régions (58, 59) de borne auxiliaire, qui ont un dopage ayant le même type de conductivité que les régions (80, 82) de borne, mais en ayant une concentration de substance de dopage plus petite d'au moins un ordre de grandeur,

et/ou **en ce que** le transistor comporte des régions de dopage auxiliaires, qui sont disposées près des régions (80, 82) de borne et/ou près des régions (58, 59) de borne auxiliaire et qui ont un dopage ayant un type de conductivité autre que les régions (80, 82) de borne et/ou les régions (58, 59) de borne auxiliaire,

et/ou **en ce que** l'électrode (54) de commande est voisine d'une zone contenant un composé métalsemiconducteur, notamment, d'une zone (92) de siliciure.

4. Circuit (140) suivant la revendication 2 ou 3, **caractérisé en ce qu'**une zone (80, 82) de borne du transistor (142) ou les deux zones (80, 82) de borne du transistor (142) sont voisines de la couche (14) isolante,

et/ou **en ce qu'**au moins une zone (80, 82) de borne est voisine d'une zone comportant un composé métalsemiconducteur, de préférence, d'une zone (90, 96) de dioxyde de silicium,

et/ou **en ce qu'**une surface limite, éloignée de la zone d'isolation, d'au moins une zone (80, 82) de borne est plus éloignée de la couche (14) d'isolation que la zone (84) active ou **en ce qu'**une surface limite, éloignée de la zone d'isolation, d'au moins une zone (80, 82) de borne est plus proche de la couche (14) d'isolation qu'une surface limite, éloignée de la zone d'isolation, de la zone (84) active.

5. Circuit (140) suivant l'une des revendications 2 à 4, **caractérisé en ce que** des deux côtés de l'électrode (54) de commande sont disposés des espaceurs (60, 62) et contiennent un matériau autre que l'électrode (54) de commande, de préférence, du dioxyde de silicium ou du nitrure de silicium,

ou qui sont en un matériau autre que l'électrode (54) de commande, de préférence, en dioxyde de silicium ou en nitrure de silicium,

et/ou **en ce que**, sur au moins un côté de la zone (56) d'électrode éloignée de la zone d'isolation, est disposé un espaceur (64, 66) qui contient un matériau autre que la zone (56) d'électrode éloignée de la zone d'isolation, de préférence, du dioxyde de silicium ou du nitrure de silicium, ou qui est en un matériau autre que la zone (56) d'électrode éloignée de la zone d'isolation, de préférence, en dioxyde de silicium ou en nitrure de silicium,

et/ou **en ce qu'**un espaceur (62a) disposé sur l'électrode (54) de commande et un espaceur (64a) disposé sur la zone (56) d'électrode éloignée de la zone d'isolation se touchent.

6. Circuit (140) suivant l'une des revendications 2 à 5, **caractérisé en ce qu'**une zone (82) de borne du transistor (142) à effet de champ et la zone (34) d'électrode, proche de la zone d'isolation, du condensateur (144) sont voisines l'une de l'autre et ont un composé conducteur de l'électricité à la limite,

et/ou **en ce que** la zone (59a) de borne voisine de la zone (34) d'électrode, proche de la zone d'isolation du transistor (152), n'est pas voisine d'une zone comportant un composé métalsemiconducteur, notamment, n'est pas voisine d'une zone de siliciure,

et/ou **en ce que** la zone (80a) de borne est voisine d'une zone (70a) contenant un composé métalsemiconducteur.

7. Circuit (140) suivant la revendication 6, **caractérisé en ce que** le côté voisin de la zone (82) de borne de la zone (34) d'électrode proche de la zone d'isolation est plus long qu'un côté, perpendiculaire à ce côté, de la zone (34) d'électrode proche de la zone d'isolation en étant, de préférence, au moins deux fois plus long ou au moins cinq fois plus long,

dans lequel le transistor a, de préférence, une largeur (W1) de transistor, qui représente un multiple de la largeur (F) minimum de structure, de préférence, plus du triple ou plus du quintuple,

ou **en ce qu'**un côté de la zone (34) d'électrode, proche de la zone d'isolation, perpendiculaire au côté, voisin de la zone (82) de borne de la zone (34) d'électrode proche de la zone d'isolation est plus long que le côté voisin de la zone (82) de borne en étant, de préférence, au moins deux fois plus long ou au moins cinq fois plus long,

dans lequel le transistor (152) a, de préférence, une largeur (W2) de transistor, qui est plus petite que le triple de la largeur (F) minimum de structure en étant, de préférence, plus petite que le double de la largeur (F) minimum de structure.

8. Circuit (140) suivant l'une des revendications précédentes, **caractérisé en ce que** la zone (34) d'électrode proche de la zone d'isolation est une zone monocristalline, de préférence, une zone semi-conductrice dopée,

et/ou **en ce que** la zone (34) d'électrode proche de la zone d'isolation et/ou la zone (84) active a une épaisseur plus petite que cent nanomètres ou plus petite que cinquante nanomètres,

et/ou **en ce que** la zone (84) active est une zone semi-conductrice, qui est dopée ou ne l'est pas,

et/ou **en ce que** la couche (14) d'isolation est voisine sur un côté d'un substrat (12) support, de préférence, d'un substrat support qui comporte un matériau semiconducteur ou qui est en un matériau semiconducteur, en étant, notamment, en silicium ou en silicium monocristallin,

et/ou **en ce que** la couche (14) d'isolation est voisine de l'autre côté de la zone (34) d'électrode proche de la zone d'isolation,

et/ou **en ce que** les surfaces limites se trouvent, de préférence, entièrement dans deux plans parallèles entre eux, et/en ce que la couche (14) d'isolation comporte un matériau isolant du point de vue électrique, de préférence, en oxyde, notamment du dioxyde de silicium ou est en un matériau isolant du point de vue électrique, de préférence, en un oxyde, notamment en dioxyde de silicium,

et/ou **en ce que** le composant (142) actif est un transistor, de préférence, un transistor à effet de champ, notamment un transistor à effet de champ planaire.

9. Circuit (140) suivant l'une des revendications précédentes, **caractérisé en ce que** la zone (46) diélectrique contient du dioxyde de silicium ou est en dioxyde de silicium,

et/ou **en ce que** la zone (46) diélectrique est en un matériau ayant une constante diélectrique plus grande que quatre ou plus grande que dix ou plus grande que cinquante,

et/ou **en ce que** la zone (56) d'électrode éloignée de la zone d'isolation contient du silicium, de préférence, du silicium polycristallin ou est en silicium, de préférence, en silicium polycristallin,

et/ou **en ce que** la zone (56) d'électrode éloignée de la zone d'isolation contient un métal ou est en un métal,

et/ou **en ce que** la zone (56) d'électrode éloignée de la zone d'isolation contient un matériau à petite valeur ohmique, de préférence, du nitrure de titane, du nitrure de tantale, du rubidium ou du silicium germanium très dopé,

et/ou **en ce que** la zone (56) d'électrode éloignée de la zone d'isolation est voisine d'une zone contenant des composés métalsemiconducteurs, notamment d'une zone (96) de siliciure.

10. Circuit (140) suivant l'une des revendications précédentes, **caractérisé en ce que** le condensateur (154) et le composant (152) actif forment une cellule (150) de mémoire dans une unité de mémoire dynamique RAM,

et/ou **en ce qu'**une cellule de mémoire comporte, soit un condensateur (152) et seulement un transistor (152), soit un condensateur (C1) et plus d'un transistor (M1 à M3), de préférence, trois transistors (M1 à M3).

11. Procédé de production d'un circuit (140) intégré ayant un condensateur (144) dans un circuit (140) suivant l'une des revendications précédentes, dans lequel, sans limitation par l'ordre indiqué, on effectue les stades de procédés suivantes :

on se procure un substrat (10), qui comprend une couche (14) isolante en matériau isolant du point de vue électrique et une couche (156) semi-conductrice,

on structure la couche (16) semi-conductrice, pour former au moins une zone (34) d'électrode pour un condensateur et pour former au moins une zone (84) active pour un transistor (142), la zone (84) active ayant une zone monocristalline,

après la structuration de la couche (16) semi-conductrice, on produit au moins une couche (42, 46) diélectrique,

après la production de la couche (42, 46) diélectrique, on produit une couche (41) d'électrode,

on forme dans la couche (41) d'électrode une électrode (56) du condensateur (144) éloignée de la zone d'isolation.

12. procédé suivant la revendication 11, **caractérisé par** les stades dans lesquels :

on dépose au moins une couche (18, 20) auxiliaire sur la couche (16) semi-conductrice avant la structuration, de préférence, une couche (20) en nitrure de silicium et/ou une couche (18) d'oxyde, la couche (20) auxiliaire servant, de préférence, de masque dur lors de la structuration de la couche (16) semi-conductrice

et/ou on dope une zone (84) de canal du transistor (142), de préférence, avant la production de la couche (42, 46) diélectrique,

on effectue une oxydation thermique pour la formation d'un oxyde (26, 28) d'arrondissement, de préférence, avant la formation de la couche (41) d'électrode,

et/ou on dope l'électrode (34) proche de la zone d'isolation, de préférence, avant la production de la couche (42, 44, 46) diélectrique,

et/ou on produit la couche (42, 46) diélectrique en même temps qu'une couche diélectrique sur la zone (84) active du transistor (122),

et/ou on forme une électrode (54) de commande du transistor (142) en même temps que l'on forme la zone (56) d'électrode éloignée de la zone d'isolation.

13. procédé suivant la revendication 11 ou 12, **caractérisé par** les stades dans lesquels :

on forme des zones (58, 59) de borne auxiliaire ayant une concentration de substance de dopage plus petite que des zones (80, 82) de borne du transistor (142), de préférence, après la structuration d'une électrode (54) de commande du transistor (142),

et/ou on forme des régions de dopage auxiliaire, de préférence, après la structuration de l'électrode (54) de commande,

on dépose une autre couche (60 à 66) auxiliaire après la structuration de l'électrode (54) de commande du transistor (142), de préférence, une couche de nitrure de silicium ou une couche d'oxyde de silicium, notamment, une couche de TEOS,

et/ou on attaque d'une façon anisotrope l'autre couche (60 à 66) auxiliaire.

**14.** procédé suivant l'une des revendications 11 à 13, **caractérisé par** les stades dans lesquels :

on effectue une épitaxie sélective sur des zones mises à nu en le matériau (16) semiconducteur après la formation de la zone (56) d'électrode éloignée de la zone d'isolation et/ou après la structuration d'une électrode (54) de commande du transistor (142),

et/ou on dope des zones (70, 72) de borne du transistor (122) après la formation de la zone (56) d'électrode éloignée de la zone d'isolation et/ou après la structuration de l'électrode (54) de commande et, de préférence, après l'épitaxie.

**15.** procédé suivant l'une des revendications 11 à 14, **caractérisé par** le stade dans lequel :

et/ou on forme sélectivement un composé métalsemiconducteur, notamment, on forme sélectivement du siliciure sur la couche (54) d'électrode et/ou sur des zones (16) semi-conductrices mises à nu.

## FIG 1

## FIG 2

## FIG 3

EP 1 552 561 B1

# FIG 4

# FIG 5

# FIG 6

20

## FIG 7

## FIG 8

## FIG 9

# FIG 10

# FIG 11

# FIG 12

# FIG 13

# FIG 14

## FIG 15

## FIG 16

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP 2000312006 A
- US 4753896 A
- US 5998807 A
- US 6462364 B1
- US 6462723 B1